# EUROPÄISCHE PATENTSCHRIFT

(11) **EP 1 297 561 B1**
(45) Veröffentlichungstag und Bekanntmachung des Hinweises auf die Patenterteilung: **03.05.2006**
(21) Anmeldenummer: 01960351.3
(22) Anmeldetag: 21.06.2001
(51) Int. Cl.: H01L 21/00, H01L 21/18

(54) **VERFAHREN UND VORRICHTUNG ZUM REINIGEN UND ANSCHLIESSENDEM BONDEN VON SUBSTRATEN**
METHOD AND DEVICE FOR CLEANING AND THEN BONDING SUBSTRATES
PROCEDE ET DISPOSITIF D'EPURATION ET DE METALLISATION SUCCESSIVE DE SUBSTRATS

(30) Priorität: 21.06.2000 DE 10030431
(43) Veröffentlichungstag der Anmeldung: 02.04.2003
(73) Patentinhaber: SUSS MicroTec Lithography GmbH, 85748 Garching (DE)
(72) Erfinder: EHRKE, Hans-Ulrich, 82319 Starnberg (DE); GABRIEL, Markus, 85748 Garching (DE); BUTTINGER, Richard, 84034 Landshut (DE)
(74) Vertreter: Vossius & Partner
(86) Internationale Anmeldenummer: PCT/EP2001/007042
(87) Internationale Veröffentlichungsnummer: WO 2001/099154

(56) Entgegenhaltungen:
- EP-A- 0 999 577
- US-A- 5 131 968
- US-A- 6 018 884
- PATENT ABSTRACTS OF JAPAN vol. 1997, no. 05, 30. Mai 1997 (1997-05-30) & JP 09 017768 A (HITACHI LTD;HITACHI SETSUBI ENG CO LTD), 17. Januar 1997 (1997-01-17)

## Beschreibung

Die Erfindung betrifft eine Vorrichtung und ein Verfahren zum Reinigen und anschließendem Bonden von Substraten (Wafem). Die Erfindung kann vorzugsweise für das direkte oder Fusionsbonden eingesetzt werden, aber auch für das Waferreinigen und nachfolgendes Bonden in einer getrennten Bondmaschine.

Beim Bonden von z.B. SOI-Wafern wird gefordert, daß Partikel oder Teilchen mit einer Größe von mehr als 0,2 µm von den zu bondenden Flächen entfernt werden müssen. Ein solcher hoher Grad von Sauberkeit bei der Wafer-Vorbereitung ist schwierig zu erreichen. Auch bei einer sehr guten Waferpräparation können neue Teilchen unmittelbar vor dem Bonden noch auf die zu verbindenden Flächen gelangen. Diese Teilchen bewirken dann, daß Blasen zwischen den gebondeten Flächen auftreten.

Aus der US-4,883,215 ist ein Verfahren zum blasenfreien Bonden von Siliziumwafem bekannt. Dieses Verfahren umfaßt die folgenden Schritte: Anordnen eines ersten und eines zweiten Wafers in geringem Abstand und parallel voneinander, Einführen einer Reinigungsflüssigkeit in den Spalt zwischen den beiden zu bondenden Oberflächen, Abspülen der Reinigungsflüssigkeit, Trocknen der gereinigten Oberflächen und Bewegen der beiden Wafer aufeinander zu, um sie in Kontakt zu bringen und zu bonden. Die Wafer werden z.B. durch Teflonabstandstücke mit einer Dicke von ungefähr 550 *µ*m gehaltert. Danach wird der Zwischenraum zwischen den Wafem in einen Strom von Wasser gespült, welches den Zwischenraum zwischen den beiden Wafern parallel zu den Waferoberflächen durchströmt. Vorzugsweise erfolgt eine Rotation der Wafer gegenüber dem Wasserstrom oder eine Rotation des Wasserstroms relativ zu den Wafern. Nach der Reinigung durch strömendes Wasser werden die Wafer durch Rotation und Abschleudern des Wassers getrocknet. Das Bonden erfolgt dann durch Beseitigung der Abstandsstücke und Druckkontakt. Die Druckschrift gibt als einen Vorteil der Methode an, daß sie auch außerhalb einer Reinraumumgebung durchgeführt werden kann.

Zum technischen Hintergrund wird noch auf folgenden Stand der Technik verwiesen: JP-A-60-72234, JP-A-9-213666 und die US-Patente U.S. 5,131,968, US 6,051,481, US 5,804,494, US 6,008,113 und US 5,129,827.

Dem gegenüber liegt der Erfindung die Aufgabe zugrunde, eine Vorrichtung und ein Verfahren zum Bonden von Substraten (Wafern) zur Verfügung zu stellen, wobei die Oberflächenqualität der zu bondenden Wafer gegenüber dem Stand der Technik weiter verbessert wird, die Vorrichtung kompakt ist und der Substratdurchsatz erhöht werden kann.

Die Aufgabe wird mit den Merkmalen der Patentansprüche gelöst.

Bei der Lösung geht die Erfindung von folgenden Grundgedanken aus.

Bei dem erfindungsgemäßen Verfahren werden mindestens zwei Substrate parallel einander gegenüberliegend angeordnet. Sie bilden zwischen sich einen Zwischenraum aus, der so groß gewählt ist, daß er mindestens eine Düse zum senkrechten Aufsprühen einer Reinigungsflüssigkeit, z.B. destilliertes hochreines Wasser oder eine andere geeignete Flüssigkeit, auf die Substratoberflächen aufnehmen kann. Die Substrate werden dann bevorzugt um ihre Mittelachse bei konstanter oder variable Drehzahl in Abhängigkeit von den Reinigungsbedingungen rotiert; Düsen werden z.B. radial über die Substrate bewegt, wobei die Reinigungsflüssigkeit schräg oder senkrecht auf die Substratoberflächen aufgesprüht oder aufgestrahlt wird. Danach wird bevorzugt die restliche Flüssigkeit durch Rotation der Substrate um ihre Mittelachse abgeschleudert, wobei der Abstand zwischen den Substraten verringert werden kann. Dann werden die Substrate miteinander in Kontakt gebracht und direkt gebondet. Während der Reinigung, Trocknung und dem Bonden wird bevorzugt in der Umgebung der zu bearbeitenden Substrate ein Mikro-Reinraum aufrecht erhalten. Das, geschieht durch die Zufuhr von Schutzgas und eine entsprechende Abschirmung, die gewährleistet, daß der Raum innerhalb der Abschirmung und insbesondere der Zwischenraum zwischen den Substraten teilchenfrei gehalten wird, die auch als Spritzschutz gegen die Reinigungsflüssigkeit dient und das Schutzgas beim Drehen, z.B. beim Tröckenschleudem, mitnimmt.

Bevorzugt wird der Bondprozeß während des Bondens (on-line) visuell überwacht und die Qualität der Verbindung der Substrate am Ende festgestellt.

Die erfindungsgemäße Vorrichtung besteht aus mindestens zwei Substrathaltem für zwei Substrate, die auf je einer Drehachse und gegeneinander bewegbar angeordnet sind und mindestens einer Düse, die in einem Zwischenraum zwischen den Substrathaltem bewegbar ist und einer Einrichtung zum Bonden der auf den Substrathattern angeordneten Substraten. Bevorzugt ist ein äußeres Gehäuse und eine Abschirmung vorgesehen, die mit einer der Drehachsen verbunden ist und in einem vorbestimmten Abstand zu einem der Substrathatter angeordnet und mit diesem bewegbar ist, um in Verbindung mit einem zugeführten Schutzgas einen Mikro-Reinraum in der Umgebung der Substrathalter auszubilden. Bevorzugt ist eine Einrichtung zur visuellen Überwachung des Bondprozesses während des Bondens und zur Feststellung der Qualität der Verbindung der Substrate vorgesehen.

Durch die Reinigung der Substrate durch einen Flüssigkeitsstrahl schräg oder senkrecht zur Substratoberfläche lassen sich hochreine Substratoberflächen erreichen, auf denen keine Teilchen mehr festgestellt werden konnten. Im Infrarottest waren die gebondeten Substrate blasenfrei. Die kompakte Ausgestaltung der Vorrichtung mit eigenem Mikro-Reinraum verringert die Abhängigkeit des Verfahrens von der Qualität der Reinraumumgebung. Außerdem erhöht die Integration der Verfahrensschritte in einer kompakten Anlage den Waferdurchsatz, da keine Unterbrechungen zwischen den einzelnen Schritten erforderlich sind. Da Luft von den Wafem vor dem Bonden ferngehalten werden kann, können auch Bondverfahren kommerziell eingesetzt werden, die bisher mit erheblichem Aufwand nur im Labormaßstab durchführbar waren. Durch die Überwachung des Bondprozesses läßt sich eine ungenügende Substraßtverbindung bereits unmittelbar nach dem Bonden feststellen; so daß eine Weiterverarbeitung verhindert werden kann.

Im folgenden wird die Erfindung anhand der Zeichnungen näher erläutert. Es zeigen:
Fig. 1 ein Prinzipbild einer Ausführungsform der erfindungsgemäßen Vorrichtung, und
Figuren 2 bis 5 Schritte des erfindungsgemäßen Verfahrens.

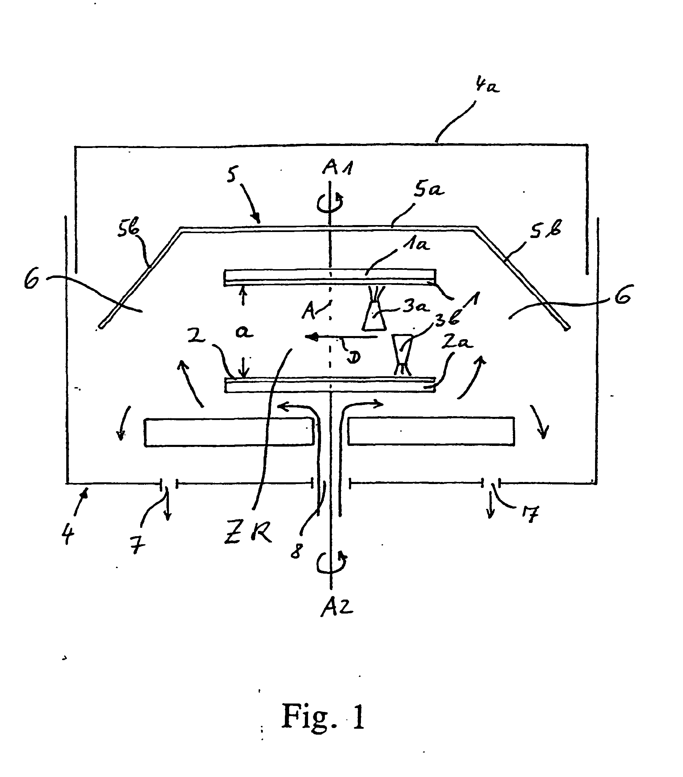

Eine Ausführungsform der erfindungsgemäßen Vorrichtung gemäß Fig. 1 besteht aus einem äußeren Gehäuse 4. In dem Gehäuse sind auf je einem Substrathalter 1a und 2a zwei Substrate 1 und 2 im Abstand a voneinander angeordnet, so daß sie einen Zwischenraum ZR ausbilden. Die Substrate 1 und 2 sind um Drehachsen A1 und A2 drehbar und in axialer Richtung gegeneinander bewegbar. Der Drehantrieb der beiden Achsen A1 und A2 erfolgt entweder unabhängig voneinander, oder die beiden Antriebe sind miteinander mechanisch gekoppelt oder elektronisch synchronisiert. Fig. 1 zeigt den Prozeßschritt der Reinigung der Substratoberflächen. Zu diesem Zweck werden bevorzugt Ultraschalldüsen, insbesondere Megaschall-Düsen 3a und 3b, im Zwischenraum ZR, bevorzugt radial (Pfeil D) bezüglich der Mittelachse A bewegt; ferner wird Reinigungsflüssigkeit schräg oder senkrecht auf die Substratoberfläche gesprüht oder gestrahlt. Der Abstand a zwischen den Substraten 1 und 2 muß also so groß eingestellt sein, daß die Düsen 3a, 3b in den Zwischenraum ZR passen. An der Drehachse A1 ist eine Abschirmung (Abschirmfläche) 5 angeordnet, die zusammen mit dem Substrathalter 1a bei der Änderung des Abstands a bewegbar ist. Die Ausbildung der Abschirmung 5 mit einer Deckplatte 5a und konisch nach außen verlaufenden Seitenwänden 5b stellt sicher, daß in dem Raum 6 innerhalb der Abschirmung und in dem Zwischenraum ZR ein Mikro-Reinraum gewährleistet ist. Auf diese Weise wird die Ablagerung von Teilchen auf den Oberflächen der Substrate 1 und 2 zuverlässig verhindert. Die Öffnungen 7 dienen zum Evakuieren des Gehäuseinnenraums bzw. zum Abpumpen des Schutzgases. Der Gehäusedeckel 4a ist zusammen mit dem Substrat 1 auf dem Substrathalter 1a in senkrechte Richtung bewegbar und kann Infrarotlampen zur Beschleunigung des Trocknungsprozesses der Substrate nach der Reinigung enthalten.

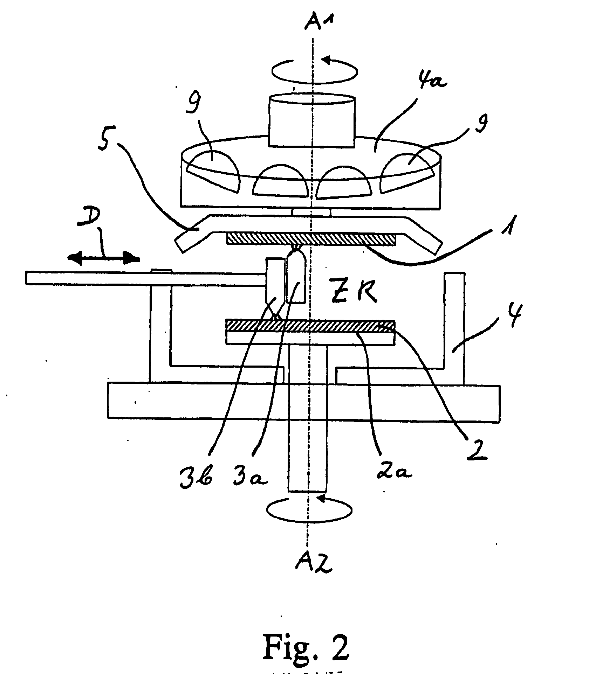

Das erfindungsgemäße Verfahren wird im folgenden anhand der Figuren 2 bis 5 erläutert.

In diesen Figuren dient die Abschirmung 5 auch als oberer Substrathalter 1a.

Fig. 2 zeigt die Reinigung der Substrate 1 und 2 mittels zweier Megaschall-Düsen 3a und 3b, die in dem Zwischenraum ZR mit Bezug zur Mittelachse A der Substrate radial über die Substratoberflächen gefahren werden (Pfeil D) und Reinigungsflüssigkeit durch Megaschallwellen senkrecht auf die Substratoberfläche sprühen. In diesem Schritt wird der Abstand zwischen den Substraten 1 und 2 auf 50 bis 250 mm eingestellt. Während des Reinigungsprozesses rotieren die Substrate 1 und 2 um die entsprechenden Drehachsen A1 und A2.

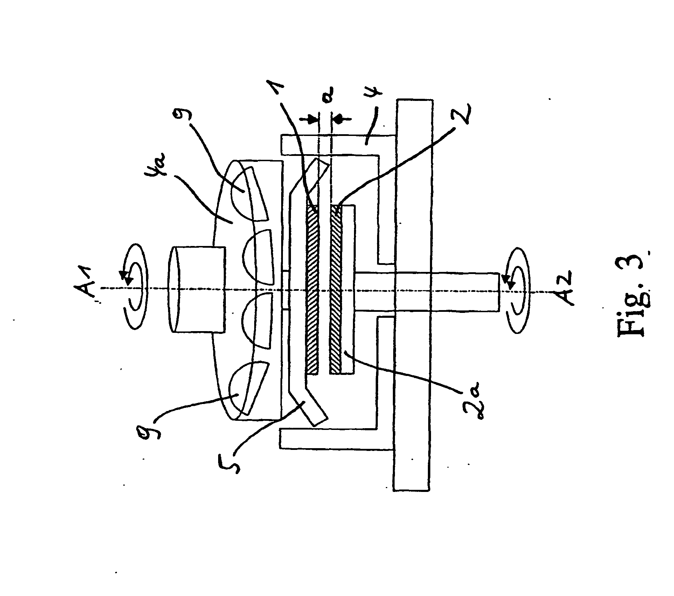

Während des Trocknungsverfahrens, das in Fig. 3 dargestellt ist, ist der Abstand zwischen den Substraten auf 2 bis 10 mm eingestellt. Die Substrate rotieren mit erhöhter Geschwindigkeit, wobei die Flüssigkeit abgeschleudert wird. Gleichzeitig wird der Bereich um die Substrate mit einem Schutzgas gefüllt bzw. gespült um einen örtlichen Mikro-Reinraum aufzubauen. Zur Beschleunigung des Trocknungsverfahrens können z.B. im Deckel 4a des Gehäuses angeordnete Infrarotlampen 9 eingesetzt werden.

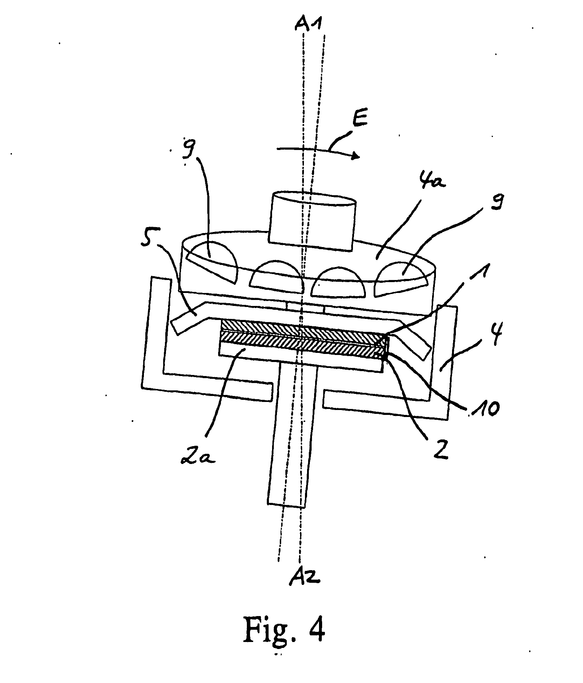

Nach dem Trocknen werden die Substrate 1 und 2 durch Absenken des Substrats 1 auf das Substrat 2 miteinander in Kontakt gebracht. Danach werden sie, wie Fig. 4 zeigt, für das Bonden zueinander ausgerichtet. Das geschieht durch Kippen und Bewegen des gesamten Gehäuses. Wie Fig. 4 zeigt, wird z.B. die Drehachse A in Pfeilrichtung E gekippt und die Substrate 1 und 2 werden parallel zu ihrer Oberfläche zur Vibration gebracht. Auf diese Weise wird bewirkt, daß die Substrate aufeinander -schwimmen bzw. gleiten und gemeinsam an einem Anschlag 10 angehalten werden, um so für das Bonden ausgerichtet zu werden.

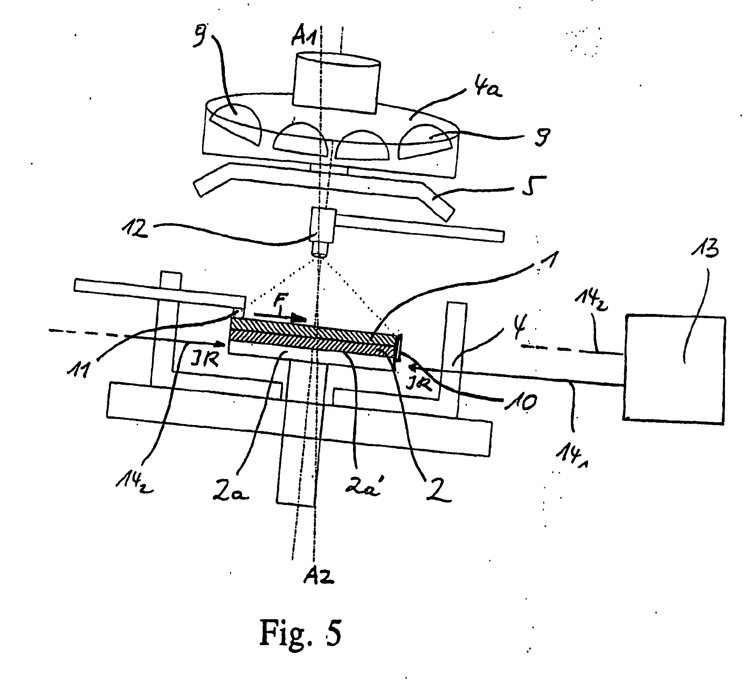

Fig. 5 zeigt das Bonden, wobei die Substrate 1 und 2 bei schräger Achsenlage seitlich durch einen Andruckstift 11 aneinander gepreßt werden. Auf diese Weise wird ein direktes Bonden von der Kante (edge bonding) aus durchgeführt, wobei sich die Bondfront in Pfeilrichtung F über die beiden Substrate bewegt. Es besteht aber auch die Möglichkeit, daß das Bonden beginnend vom Zentrum der Substrate (center bonding) durchgeführt wird.

Zwischen der Abschirmfläche 5, die nach dem Ablegen des Substrats 1 auf dem Substrat 2 nach oben gefahren wird, und dem Substrat 1 kann eine Infrarot (IR)-Kamera 12 eingeführt werden. Die IR-Kamera 12 detektiert IR (Infrarot-)-Licht, das durch eine IR-Lichtquelle 13 erzeugt wird und bevorzugt durch einen oder mehrere Lichtleiter 14₁, 14₂ seitlich in den Substrathalter 2a eingekoppelt wird. Das IR-Licht wird durch das entsprechend ausgewählte Material des Substrathalters 2a oder zumindest einer Schicht davon diffus gestreut, tritt aus der Oberfläche 2a' des Substrathalters 2a in das Substrat 2 ein, durchdringt die gebondeten Flächen der Substrate 2 und 1 und anschließend das Substrat 1 und wird schließlich nach dem Austritt aus der freien Oberseite des Substrats 1 durch die IR-Kamera 12 erfaßt. Die Qualität der Substratverbindung wird durch den Kontrast des IR-Lichtes in der IR-Kamera 12 sichtbar gemacht. Durch z.B. Einschlüsse zwischen den gebondeten Flächen wird der Kontrast geändert, so daß der Kontrast des IR-Lichts ein Maß für die Qualität der Substratbondverbindung bildet.

Mittels des erfindungsgemäßen Verfahrens und der erfindungsgemäßen Vorrichtung lassen sich Substrate (Wafer) mit einer Größe von 100 bis 200 mm und größer bearbeiten. Eine typische Prozeßzykluszeit ist 5 Minuten, die jedoch von dem speziellen Prozeß abhängig ist. Bereits bei einer Frequenz von 1 MHz erlauben die Megaschall-Düsen das Entfernen von Teilchen bis zu einem Durchmesser von 0,1 *µ*m, mit einer Frequenz von 3 MHz werden Teilchen bis zu einem Durchmesser von 0,03 *µ*m entfernt.

## Patentansprüche

1. Verfahren zum Reinigen und anschließendem Bonden von zwei oder mehr Substraten, mit den Schritten:
a) Anordnen von mindestens zwei Substraten (1, 2), so daß diese parallel einander gegenüberliegen und zwischen sich einen Zwischenraum (ZR) ausbilden, wobei der Zwischenraum so groß gewählt wird, daß er mindestens eine Düse zum Aufsprühen einer Reinigungsflüssigkeit auf die Substrate (1, 2) aufnehmen kann,
b) Rotieren der Substrate (1, 2) um ihre Mittelachse (A), Bewegen der Düse über die Substrate und Sprühen von Reinigungsflüssigkeit schräg oder senkrecht auf die Oberfläche der Substrate (1, 2),
c) Trocknen der Substrate und,
d) direktes Bonden der Substrate (1, 2).

2. Verfahren nach Anspruch 1, wobei die Reinigungsflüssigkeit mittels je einer Düse (3a bzw. 3b)für jede zu reinigende Substratoberfläche aufgesprüht wird.

3. Verfahren nach Anspruch 1 oder 2 wobei im Verfahrensschritt c) zum Trocknen der Substrate die restliche Reinigungsflüssigkeit durch Rotation der Substrate um die Mittelachse (A) abgeschleudert wird.

4. Verfahren nach Anspruch 1, 2 oder 3, wobei die Düse oder die Düsen (3a, 3b) mit Bezug auf die Mittelachse der Substrate (1, 2) radial über die Substratoberflächen bewegt wird/werden.

5. Verfahren nach einem der Ansprüche 1 bis 4, wobei das Verfahren in einem Mikro-Reinraum durchgeführt wird.

6. Verfahren nach einem der Ansprüche 1 bis 5, wobei die Substrate (1, 2) während der Verfahrensschritte a) bis c) und gegebenenfalls d) in einem Gehäuse (4) eingeschlossen sind.

7. Verfahren nach Anspruch 5 oder 6, wobei der Mikro-Reinraum durch eine mit der Drehachse (A1) einer Substrathalterung (1a) eines der Substrate (1, 2) verbundene Abschirmfläche (5) begrenzt wird, die mit der oder als die Substrathalterung (1a) in Richtung der Änderung des Abstands (a) der Substrate (1, 2) bewegbar ist.

8. Verfahren nach einem der Ansprüche 1 bis 7, wobei während des Schrittes c) oder unmittelbar nach diesem Schritt c) eine Trocknung der Substrate (1, 2) durch eine Infrarot-Heizung (9) erfolgt.

9. Verfahren nach einem der Ansprüche 1 bis 8, wobei in Schritt a) und b) der Abstand (a) der Substrate (1, 2) auf 50 bis 250 mm eingestellt wird.

10. Verfahren nach einem der Ansprüche 1 bis 9, wobei in Schritt c) der Abstand (a) auf 2 bis 10 mm eingestellt wird.

11. Verfahren nach einem der Ansprüche 1 bis 10, wobei mindestens zwei Ultraschalldüsen (3a, 3b) verwendet werden.

12. Verfahren nach Anspruch 11, wobei mindestens zwei Megaschall-Düsen (3a, 3b) verwendet werden.

13. Verfahren nach Anspruch 12, wobei die Megaschall-Düsen (3a, 3b) bei einer Frequenz von ≥ 1 MHz betrieben werden.

14. Verfahren nach einem der Ansprüche 1 bis 13, wobei ein Schutzgas zugeführt wird, das den Raum (6) innerhalb der Abschirmfläche (5), zumindest aber den Zwischenraum (ZR) zwischen den Substraten (1, 2) ausfüllt.

15. Verfahren nach einem der Ansprüche 1 bis 14, wobei nach dem Trocknen der Abstand (a) zwischen den Substraten (1, 2) verringert wird.

16. Verfahren nach Anspruch 15, wobei der verringerte Abstand (a) 0,05 bis 0,5 mm, vorzugsweise 0,1 mm beträgt.

17. Verfahren nach einem der Ansprüche 1 bis 16, wobei zwischen den Schritten c) und d) eine Ausrichtung der Substrate (1, 2) zueinander durch Kippen der Mittelachse (A) und Vibrieren der Substrate (1, 2) erfolgt, so daß die Substrate (1,2) aufeinander bis zu einem gemeinsamen Anschlag (10) gleiten.

18. Verfahren nach einem der Ansprüche 1 bis 17, wobei das Bonden mittels eines Andruckstiftes (11) durch im wesentlichen punktfömigen Kontakt der Substrate (1, 2) am Rand, in der Mitte oder an anderer Stelle oder durch fortschreitendes flächiges Kontaktieren erfolgt.

19. Verfahren nach einem der Ansprüche 1 bis 18, wobei im Verfahrensschnitt d) der Bondprozeß überwacht und am Ende des Bondprozesses die Qualität der Verbindung der Substrate (1, 2) festgestellt wird.

20. Verfahren nach Anspruch 19, wobei die Überwachung des Bondprozesses mittels IR-Licht, das die Substrate (1, 2) durchdringt, erfolgt.

21. Verfahren nach Anspruch 20, wobei das aus dem Substrat (1) austretende IR-Licht durch eine IR-Kamera (12) erfaßt und die Qualität der Substratverbindung durch den ermittelten Kontrast des IR-Lichtes festgestellt wird.

22. Vorrichtung zum Reinigen und anschließendem Bonden von zwei oder mehr Substraten mit:
a) einem äußeren Gehäuse (4),
b) mindestens zwei einander parallel gegenüberüegenden, auf je einer Drehachse (A1, A2) angeordneten Substrathaltem (1a, 2a), die in Richtung der Drehachsen (A1, A2) gegeneinander bewegbar sind, zum Haltern von jeweils einem Substrat (1 bzw. 2),
c) mindestens einer Düse (3a, 3b), die in einem Zwischenraum (ZR) zwischen den Substrathaltem (1a, 2a) bewegbar ist, um die Substrate (1, 2) mit Reinigungsflüssigkeit zu besprühen,
d) optional einer Abschirmfläche (5), die mit einer der Drehachsen (A1) verbunden und zusammen mit einem der Substrathalter (1a) bewegbar ist, um die Ablagerung von Teilchen auf den Oberflächen der Substrate (1, 2) zu verhindern, als Spritzschutz zu dienen und Schutzgas (8) beim Drehen mitzunehmen,
e) einer Einrichtung zum direkten Bonden von auf den Substrathaltern (1 a, 2a) angeordneten Substraten.

23. Vorrichtung nach Anspruch 22, wobei das äußere Gehäuse (4) Öffnungen zum Evakuieren (7) und Zuführen eines Schutzgases (8) aufweist, so daß in dem Raum (6) innerhalb der Abschirmung (5), zumindest aber in dem Zwischenraum (ZR) ein Mikro-Reinraum ausgebildet ist.

24. Vorrichtung nach Anspruch 22 oder 23, wobei die Abschirmfläche (5) aus einer zur Drehachse (A1) konzentrischen Deckplatte (5a) mit nach außen konisch verlaufenden Seitenwänden (5b) besteht.

25. Vorrichtung nach einem der Ansprüche 22 bis 24, wobei eine Infrarot-Heizung (9) zum Trocknen der Substrate (1, 2) vorgesehen ist.

26. Vorrichtung nach einem der Ansprüche 22 bis 25, wobei Einrichtungen vorgesehen sind, um die Drehachsen (A1, A2) zum Kippen und die Substrate (1, 2) parallel zu ihren Oberflächen auf den Substrathaltern (1a, 2a) zum Vibrieren zu bringen, um sie an einem Anschlag (10) für das Bonden auszurichten.

27. Vorrichtung nach einem der Ansprüche 22 bis 26, wobei die Einrichtung zum Bonden einen Andruckstift (11) aufweist, der die Substrate (1, 2) aneinanderdrückt.

28. Vorrichtung nach einem der Ansprüche 22 bis 27, mit einer Einrichtung zur Überwachung des Bondprozesses während des Bondens und zum Feststellen der Qualität der Verbindung der Substrate (1, 2).

29. Vorrichtung nach Anspruch 28, wobei die Einrichtung zur Überwachung des Bondprozesses eine IR-Lichtquelle und eine IR-Kamera (12) zum Empfangen von IR-Licht, das die Substrate (1, 2) durchdringt, aufweist.

30. Vorrichtung nach Anspruch 29, wobei eine oder mehrere IR-Lichtquelle(n) (13) unterhalb des unteren Substrats (2) auf der von der Abschirmfläche (5) abgewandten Seite und die IR-Kamera (12) zwischen dem oberen Substrat (1) und der Abschirmfläche (5) angeordnet ist.

31. Vorrichtung nach Anspruch 30, wobei das IR-Licht an den Substrathalter (2a) angekoppelt ist, der aus einem zumindest teilweise IR-lichtdurchlässigen Material besteht.

32. Vorrichtung nach Anspruch 31, wobei das IR-Licht durch eine oder mehrere Lichtfasern (14₁, 14₂) in den Substrathalter (2a) eindringt, in diesem diffus gestreut wird, mit im wesentlichen homogener Intensität die Oberfläche 2a des Substrathalters (2a') verläßt und die gebondeten Substrate (1 und 2) durchdringt, wobei in der IR-Kamera (12) ein Bild der Verbindungsschicht der Substrate (1 und 2) entsteht.

33. Verwendung der Vorrichtung nach einem der Ansprüche 22 bis 31 beim direkten Kanten- oder Zentrumsbonden.

## Claims

1. A method for cleaning and then bonding two or more substrates comprising the steps of
(a) arranging at least two substrates (1, 2) so that they are parallel and opposite to each other and form a gap (ZR) between each other, wherein the gap is so large that it can receive at least one nozzle for spraying a cleansing substrate onto the substrates (1, 2),
(b) rotating the substrates (1, 2) around their center axis (A), moving the nozzle over the substrates and spraying a cleansing liquid obliquely or vertically onto the surface of the substrates (1, 2),
(c) drying the substrates, and
(d) directly bonding the substrates (1, 2).

2. The method according to claim 1, wherein the cleansing liquid is sprayed by means of one nozzle (3a or 3b) for each substrate surface to be cleaned.

3. The method according to claim 1 or 2, wherein in method step (c) the remaining cleansing liquid is spun off by rotating the substrates around the center axis (A) in order to dry the substrates.

4. The method according to claim 1, 2 or 3, wherein the nozzle or the nozzles (3a, 3b) is/are moved radially with respect to the center axis of the substrates (1, 2) over the substrate surfaces.

5. The method according to any one of claims 1 to 4, wherein the method is carried out in a micro-clean room.

6. The method according to any one of claims 1 to 5, wherein the substrates (1, 2) are confined in a housing (4) during method steps (a) to (c) and optionally (d).

7. The method according to claim 5 or 6, wherein the micro-clean room is limited by a shielding surface (5) which is connected with the rotational axis (A1) of a substrate support (1a) of one of the substrates (1, 2) and which can be moved together with or as the substrate support (1a) in the direction of the change of the distance (a) of the substrates (1, 2).

8. The method according to any one of claims 1 to 7, wherein during step (c) or directly after this step (c) the substrates (1, 2) are dried by an infrared heater (9).

9. The method according to one of claims 1 to 8, wherein in steps (a) and (b) the distance (a) between the substrates (1, 2) is adjusted to 50 to 250 mm.

10. The method according to any one of claims 1 to 9, wherein in step (c) the distance (a) is adjusted to 2 to 10 mm.

11. The method according to any one of claims 1 to 10, wherein at least two ultrasonic nozzles (3a, 3b) are used.

12. The method according to claim 11, wherein at least two megasonic nozzles (3a, 3b) are used.

13. The method according to claim 12, wherein the megasonic nozzles (3a, 3b) are operated at a frequency of ≥ 1 MHz.

14. The method according to any one of claims 1 to 13, wherein an inert gas is added which fills the room (6) within the shielding surface (5), at least, however, the gap (ZR) between the substrates (1, 2).

15. The method according to any one of claims 1 to 14, wherein the distance (a) between the substrates (1, 2) is reduced after drying.

16. The method according to claim 15, wherein the reduced distance (a) is 0.05 to 0.5 mm, preferably 0.1 mm.

17. The method according to any one of claims 1 to 16, wherein between steps (c) and (d) the substrates (1, 2) are aligned with respect to each other by tilting the center axis (A) and vibrating the substrates (1, 2) so that the substrates (1, 2) slide on one another until they reach a common stop (10).

18. The method according to any one of claims 1 to 17, wherein bonding is caused by means of a pressure pin (11) by an essentially punctiform contact of the substrates (1, 2) at the edge, in the middle or at any other point or by a progressive planar contact.

19. The method according to any one of claims 1 to 18, wherein the bonding process is monitored in method step (d) and the quality of the bond between the substrates (1, 2) is determined at the end of the bonding process.

20. The method according to claim 19, wherein the bonding process is monitored by means of IR light passing through the substrates (1, 2).

21. The method according to claim 20, wherein the IR light emerging from the substrate (1) is detected by an IR camera (12), and the quality of the substrate bond is determined by the ascertained contrast of the IR light.

22. A device for cleaning and then bonding two or more substrates comprising:
(a) an outer housing (4),
(b) at least two parallel and opposite substrate holders (1a, 2a), which are each arranged on one rotational axis (A1, A2) and can be moved with respect to one another in the direction of the rotational axes (A1, A2) and which serve for holding at least one substrate (1, 2 respectively),
(c) at least one nozzle (3a, 3b) which is movable in a gap (ZR) between the substrate holders (1a, 2a) in order to spray cleansing liquid onto the substrates (1, 2),
(d) optionally a shielding surface (5) which is connected with one of the rotational axes (A1) and can be moved together with one of the substrate holders (1a) in order to prevent the deposition of particles on the surfaces of the substrates (1, 2), to serve as a splash guard and to take inert gas (8) with it during rotation,
(e) a means for direct bonding of substrates being arranged on the substrate holders (1a, 2a).

23. The device according to claim 22, wherein the outer housing (4) has openings for evacuating (7) and supplying an inert gas (8) so that a micro-clean room is created in the room (6) within the shielding (5), at least, however, in the gap (ZR).

24. The device according to claim 22 or 23, wherein the shielding surface (5) consists of a cover plate (5a) being concentric with respect to the rotational axis (A1) and comprising side walls (5b) extending conically outwards.

25. The device according to any one of claims 22 to 24, wherein an infrared heating (9) is provided for drying the substrates (1, 2).

26. The device according to any one of claims 22 to 25, wherein means are provided for tilting the rotational axes (A1, A2) and causing the substrates (1, 2) to vibrate on the substrate holders (1a, 2a) parallel with respect to their surfaces in order to align them on a stop (10) for being bonded.

27. The device according to any one of claims 22 to 26, wherein the means for bonding comprises a pressure pin (11) which presses the substrates (1, 2) together.

28. The device according to any one of claims 22 to 27 comprising a means of monitoring the bonding process during bonding and for determining the quality of the bond between the substrates (1, 2).

29. The device according to claim 28, wherein the means for monitoring the bonding process comprises an IR light source and an IR camera (12) for receiving IR light which passes through the substrates (1, 2).

30. The device according to claim 29, wherein one or a plurality of IR light source(s) (13) is/are arranged below the lower substrate (2) on the surface opposite the shielding surface (5) and the IR camera (12) is arranged between the upper substrate (1) and the shielding surface (5).

31. The device according to claim 30, wherein the IR light is coupled to the substrate holder (2a) which consists of an at least partially IR-light-permeable material.

32. The device according to claim 31, wherein the IR light enters the substrate holder (2a) through one or a plurality of light fibers (14₁, 14₂), is diffusely scattered therein, leaves the surface (2a) of the substrate holder (2a') with an essentially homogeneous intensity and passes through the bonded substrates (1 and 2), wherein an image of the bond layer of the substrates (1 and 2) is generated in the IR camera (12).

33. The use of the device according to any one of claims 22 to 31 for direct edge or center bonding.

## Revendications

1. Procédé de nettoyage et de liaison consécutive de deux ou plusieurs substrats, avec les étapes :
a) d'agencement d'au moins deux substrats (1, 2), de façon à ce que ceux-ci reposent parallèlement l'un à l'autre, et de formation entre eux d'un espace intermédiaire (ZR), dans lequel l'espace intermédiaire est choisi avec une taille telle qu'il peut recevoir une buse pour pulvériser un liquide de nettoyage sur les substrats (1,2).
b) de rotation des substrats (1, 2) sur leur axe médian (A), de déplacement de la buse au-dessus des substrats et de pulvérisation du liquide de nettoyage en biais ou à la verticale sur la surface des substrats (1,2).
c) de séchage des substrats, et
d) de liaison directe des substrats (1, 2).

2. Procédé selon la revendication 1, dans lequel le liquide de nettoyage est pulvérisé au moyen d'une buse respective (3a ou 3b) pour chaque surface de substrat à nettoyer.

3. Procédé selon la revendication 1 ou 2, dans lequel dans l'étape de procédé c) pour le séchage des substrats, le liquide de nettoyage restant est projeté par la rotation des substrats sur l'axe médian (A).

4. Procédé selon la revendication 1, 2 ou 3, dans lequel la buse ou les buses (3a, 3b) par rapport à l'axe médian des substrats (1, 2) est/sont déplacée(s) radialement au-dessus des surfaces des substrats.

5. Procédé selon l'une des revendications 1 à 4, dans lequel le procédé est réalisé dans une salle blanche en microcosme.

6. Procédé selon l'une des revendications 1 à 5, dans lequel les substrats (1, 2) sont fermés dans un boîtier (4) durant les étapes de procédé a) à c) et le cas échéant d).

7. Procédé selon la revendication 5 ou 6, dans lequel la salle blanche en microcosme est limitée par une surface de blindage (5) qui est liée avec l'axe de rotation (A1) d'un support de substrat (1a) d'un des substrats (1,2), et qui est mobile avec ledit support de substrat ou en tant que support de substrat (1a) dans le sens de la modification de l'écart (a) des substrats (1,2).

8. Procédé selon l'une des revendications 1 à 7, dans lequel pendant l'étape c) on directement après cette étape c), un séchage des substrats (1, 2) s'effectue par un chauffage à infrarouges (9).

9. Procédé selon l'une des revendications 1 à 8, dans lequel dans l'étape a) et l'étape b), l'écart (a) des substrats (1, 2) est réglé de 50 à 250 mm.

10. Procédé selon l'une des revendications 1 à 9, dans lequel dans l'étape c), l'écart (a) est réglé de 2 à 10 mm.

11. Procédé selon l'une des revendications 1 à 10, dans lequel au moins deux buses à ultrasons (3a, 3b) sont employées.

12. Procédé selon la revendication 11, dans lequel au moins deux buses à mégasons (3a, 3b) sont employées.

13. Procédé selon la revendication 12, dans lequel les deux buses à mégasons (3a,3b) sont exploitées à une fréquence ≥ 1 MHz.

14. Procédé selon l'une des revendications 1 à 13, dans lequel un gaz de protection est amené qui remplit l'espace (6) à l'intérieur de la surface de blindage (5), et au moins toutefois l'espace intermédiaire (ZR) entre les substrats (1, 2).

15. Procédé selon l'une des revendications 1 à 14, dans lequel après le séchage, l'écart (a) entre les substrats (1, 2) est réduit.

16. Procédé selon la revendication 15, dans lequel l'écart (a) réduit est de 0,05 à 0,5 mm, de préférence 0,1 mm.

17. Procédé selon l'une des revendications 1 à 16, dans lequel entre les étapes c) et d), un alignement des substrats (1, 2) l'un vers l'autre se produit par le pivotement de l'axe médian (A) et la vibration des substrats (1, 2), de façon à ce que les substrats (1, 2) glissent l'un sur l'autre jusqu'à une butée commune (10).

18. Procédé selon l'une des revendications 1 à 17, dans lequel la liaison s'effectue au moyen d'une tige de pression (11) par un contact principalement ponctuel des substrats (1, 2) sur le bord, au milieu ou à un autre emplacement, ou par une mise en contact progressive en deux dimensions.

19. Procédé selon l'une des revendications 1 à 18, dans lequel le processus de liaison est surveillé dans l'étape d), et la qualité de la liaison des substrats (1, 2) est établie à la fin du processus de liaison.

20. Procédé selon la revendication 19, dans lequel la surveillance du processus de liaison s'effectue au moyen d'une lumière à infrarouges qui pénètre à travers les substrats (1,2).

21. Procédé selon la revendication 20, dans lequel la lumière à infrarouges sortant du substrat (1) est saisie par une caméra à infrarouges (12) et la qualité de la liaison de substrat est établie par le contraste obtenu de la lumière à infrarouges.

22. Procédé de nettoyage et de liaison consécutive de deux ou plusieurs substrats, avec :
a) un boîtier extérieur (4),
b) au moins deux supports de substrats (1a, 2a) reposant parallèlement l'un à l'autre, respectivement sur deux axes de rotation (A1, A2) qui sont mobiles l'un par rapport à l'autre dans le sens des axes de rotation (A1, A2), pour supporter chacun un substrat (1 ou 2),
c) au moins une buse (3a, 3b) qui est mobile dans un espace intermédiaire (ZR) entre les supports de substrats (1a, 2a) pour pulvériser les substrats (1, 2) avec un liquide de nettoyage,
d) en option, une surface de blindage (5) qui est reliée à l'un des axes de rotation (A1) et est mobile conjointement avec un des supports de substrats (1a), pour-éviter le dépôt de particules, sur les surfaces des substrats (1,2), et pour servir de protection de pulvérisation et entraîner un gaz de protection (8) lors de la rotation,
e) un dispositif pour la liaison directe des substrats placés sur les supports de substrats (1a, 2a).

23. Dispositif selon la revendication 22, dans lequel le boîtier extérieur (4) présente des ouvertures pour évacuer (7) et amener un gaz de protection (8), de façon à ce que dans l'espace (6) à l'intérieur du blindage (5), et au moins toutefois dans l'espace intermédiaire (ZR), une salle blanche en microcosme soit formée.

24. Dispositif selon la revendication 22 ou 23, dans lequel la surface de blindage (5) est composée d'une plaque de couverture (5a) concentrique par rapport à l'axe de rotation (A1) avec des parois latérales s'étendant de manière conique vers l'extérieur (5b).

25. Dispositif selon l'une des revendications 22 à 24, dans lequel un chauffage à infrarouges (9) est prévu pour le séchage des substrats (1,2).

26. Dispositif selon l'une des revendications 22 à 25, dans lequel des appareils sont prévus afin d'amener en pivotement les axes de rotation (A1, A2) et d'amener en vibration les substrats (1, 2) Parallèles à leurs surfaces sur les supports de substrats (1a, 2a), pour les diriger sur une butée (10) pour la liaison.

27. Dispositif selon l'une des revendications 22 à 26, dans lequel l'appareil pour la liaison présente une tige, de pression (11) qui appuie les substrats (1, 2) l'un sur l'autre.

28. Dispositif selon l'une des revendications 22 à 27, avec un appareil de surveillance du processus de liaison pendant la liaison et pour l'établissement de la qualité de liaison des substrats (1, 2).

29. Dispositif selon la revendication 28, dans lequel l'appareil de surveillance du processus de liaison présente une source lumineuse à infrarouges et une caméra à infrarouges (12) pour recevoir de la lumière à infrarouges, qui pénètre à travers les substrats (1, 2).

30. Dispositif selon la revendication 29, dans lequel une ou plusieurs source(s) lumineuse(s) (13) est placée sous le substrat inférieur (2) sur la face opposée à la surface de blindage (5) et la caméra à infrarouges (12) entre le substrat supérieur (1) et la surface de blindage (5).

31. Dispositif selon la revendication 30, dans lequel la lumière à infrarouges est couplée au support de substrat (2a) qui est composé d'un matériau qui laisse passer au moins partiellement la lumière à infrarouges.

32. Dispositif selon la revendication 31, dans lequel la lumière à infrarouges pénètre par une ou plusieurs fibre(s) optique(s) (14₁, 14₂) dans le support de substrat (2a), est diffusée dans celui-ci, quitte la surface (2a) du support de substrat (2a'), avec une intensité principalement homogène et pénètre à travers les substrats liés (1 et 2), dans lequel une image de la couche de liaison des substrats (1 et 2) apparaît dans la caméra à infrarouges (12).

33. Utilisation du dispositif selon l'une des revendications 22 à 31 lors de la liaison centrale ou sur chant.
